# EUROPEAN PATENT SPECIFICATION

(11) **EP 2 161 841 B1**
(45) Date of publication and mention of the grant of the patent: **12.12.2012**
(21) Application number: 08290840.1
(22) Date of filing: 08.09.2008
(51) Int. Cl.: H04B 1/04, H03F 1/32

(54) **Predistortion of a radio frequency signal**
Vorverzerrung eines Hochfrequenzsignals
Prédistorsion d'un signal de fréquence radio

(43) Date of publication of application: 10.03.2010
(73) Proprietor: Alcatel Lucent, 75007 Paris (FR)
(72) Inventor: Maier, Michael, 72074 Tübingen (DE); Ziegler, Rainer, 70563 Stuttgart (DE)
(74) Representative: Wetzel, Emmanuelle

(56) References cited:
- EP-A- 1 612 933
- EP-A- 1 657 814
- WO-A-2005/112253

## Description

### Field of the invention

The present invention relates to a method for performing predistortion of a radio frequency signal, a computer program product, a radio transmitter, a mobile telecommunications system comprising such radio transmitter, and a mobile phone comprising such radio transmitter. In particular, the present invention relates to adjusting predistortion of a radio frequency signal over its total bandwidth.

### Background and prior art

Active linearization has become an important technology in modern communication systems. In new generation mobile communication systems where spectrum efficient linear modulation formats are used, power amplifier linearity is a key requirement. Typically, power amplifiers are operated near to saturation where they are highly efficient but extremely non-linear.

Therefore, the disadvantage of operating a power amplifier near to saturation is that due to the amplifier non-linearity a resultant amplified signal comprises besides the amplified wanted signal intermodulation distortion signals located at frequencies above and at frequencies below the desired wanted output signal. Intermodulation distortion is highly undesirable, because it causes interference, cross talk and other effects which need to be suppressed in order to comply with requirements regarding transmitted signals in for example mobile communication systems.

Generally, intermodulation distortion can be reduced by different power amplifier linearization methods which can be classified mainly as feedback, feed forward and predistortion. Even though predistortion is known to be a complicated linearization method applicable in telecommunication base stations, where extremely high linearity is required, it has been shown that with a careful design it is also applicable in handsets resulting in significant linearity improvement.

The concept of the predistortion technique is to insert a non-linear module between the input signal and the power amplifier. The non-linear module generates intermodulation distortion products, which are in anti phase with the intermodular distortion products produced by the power amplifier, reducing out of band emissions. This means, that the input signal is expanded prior to a power amplifier in such a way, that the non-linearities generated by the power amplifier are compensated. The predistortion circuit inversely models the amplifier's gain and phase characteristics and, when combined with the amplifier, produces an overall system that is more linear. Therewith, out of band emissions generated by the amplifier can be drastically reduced.

There are known methods for performing predistortion to improve the linearity of radio transmitter power amplifiers. For example US 5,877,653 describes a linear power amplifier and method for removing the intermodulation distortion with a predistortion system and a feed forward system. US 6,757,338 describes a predistortion linearizer for predistorting a radio frequency signal. EP 1 434 299 A1 describes a method and apparatus for an adaptively predistorted filter which has a transfer function that satisfies performance criteria specified for at least one property of the filter. EP-A-1 657 814 describes distortion compensating units which compensate for distortion on low- and high-frequency sides. A low-frequency portion and a high-frequency portion of a carrier signal are multiplied by different frequencies and separately converted into digital signals. EP-A-1 612 933 describes a distortion compensation device that compensates for distortion generated in a signal amplified by an amplifier by means of first and second distortion generation means. WO 2005/112253 A describes an adaptive predistortion method, in which a pre-distorted baseband signal is converted into a radio frequency signal to be transmitted. The baseband signal is up-converted into an intermediate frequency signal having frequency aliasing, and the radio frequency signal is down-converted into an intermediate frequency signal having the same frequency aliasing as said up-converted base band signal. Furthermore, predistortion parameters are adapted to keep said up-converted baseband signal equal to said down-converted radio frequency signal.

However, such predistortion techniques typically apply predistortion to a rather large signal bandwidth comprising both, the wanted signal and the intermodulation signals at frequencies below and above the desired output signal. This has the disadvantage, that high bandwidth predistortion circuits are required, which is rather cost intensive. Also, operation of such high-bandwidth circuits is rather power consuming. Another disadvantage is, that due to the still limited bandwidth of such highly sophisticated predistortion circuits it is rather impossible to pre-distort an amplified signal regarding its total frequency bandwidth.

For example, if predistortion is carried out in a feedback path of a radio transmitter the signal in the feedback path passes an analog-to-digital (AD) converter. However, known AD converters have only limited performance, since the total bandwidth of the signal which has to be transmitted is larger than the bandwidth of the AD converter. This limited bandwidth of the AD converter causes limited and insufficient predistortion performance. Furthermore, in case of predistortion in the feedback path of a radio transmitter, the predistortion performance of mobile radio infrastructure depends mainly on the performance of the AD converter located therein.

It is therefore an object of the present invention to provide an improved predistortion technique in a feedback path of a radio transmitter.

This object and other objects are solved by the features of the independent claims. Preferred embodiments of the invention are described by the features of the dependent claims.

### Summary of the invention

The present invention provides for adjusting predistortion of a radio frequency signal in a feedback path of a radio transmitter, wherein the feedback path of the radio transmitter comprises at least a coupler, a local oscillator, a mixer, and an analogue-to-digital converter. The coupler couples a radio frequency output signal of the radio transmitter to the predistortion feedback path. According to the present invention the local oscillator successively generates different frequencies and feeds said frequencies into the mixer. Thus, the mixer is able to successively generate at least two different frequency shifted signals by multiplying said radio frequency signals by said frequencies. After successively converting the frequency shifted signals into different digital signals, said different digital signals are summed up to a single digital signal.

By appropriately selecting the at least two frequencies of the local oscillator and by successively multiplying the radio frequency output signal of the radio transmitter by said different frequencies it is possible to frequency shift the output signal in such a way that only a desired portion of the respectively generated frequency shifted signals passes the analogue-to-digital converter. In other words, according to the present invention the frequency of the local oscillator in the feedback path is adjusted to at least two specific frequencies, which are mixed with the radio frequency output signal of the radio transmitter in successive steps. As mentioned above, conventional analogue-to-digital converters have a limited bandwidth which is usually smaller than the bandwidth of the signal to be converted. According to the present invention the analogue-to-digital converter is able to convert desired portions of different mixed signals, that is, different frequency shifted signals, with different frequency components of the feedback signal. Consequently, the radio transmitter provides better performance.

Furthermore, according to the present invention at least two bandwidth sections of the radio frequency signal are determined, each bandwidth section being smaller than the total bandwidth of the radio frequency signal. Based on such first and at least one further bandwidth section the at least two frequency shifted signals are generated by multiplying each bandwidth section by a corresponding frequency. That is, the local oscillator generates different frequencies for the at least corresponding frequency. That is, the local oscillator generates different frequencies for the at least two bandwidth sections to generate the at least two frequency shifted signals. Since only bandwidth sections of the radio frequency signal are multiplied by the corresponding frequency and not the total bandwidth of the radio frequency signal, processing power is reduced. In particular, the use of limited predistortion bandwidth as described above is preferred to get a strongly improved radio transmitter performance. In addition, higher efficiencies and cost savings can be achieved, since the limited predistortion bandwidth leads, due to lower technical demands on respective components, to considerable cost savings. Up to now, components with the required bandwidth are not available.

According to a further embodiment of the present invention the at least two bandwidth sections cover the total bandwidth of the radio frequency signal. In addition, said at least two bandwidth sections may partially overlap. Thus, all frequency components of the feedback signal are converted and can be considered for the calculation of the predistortion parameters in a further process, wherein the conversion of the frequency components occurs in successive steps. It should be noted that the total bandwidth of the radio frequency signal can be divided into more than two bandwidth sections resulting in a corresponding number of conversion steps. Preferably, the bandwidth of the bandwidth sections is selected in accordance with the bandwidth of the analogue-to-digital converter. Since all spectral components of the radio frequency signal (feedback signal) are analog-to-digital converted, a significantly improved predistortion result can be obtained.

According to a still further embodiment of the present invention the first frequency shifted signal comprises lowest spectral components of the radio frequency signal and each further frequency shifted signal comprises next higher spectral components of the radio frequency signal. Alternatively, the first frequency shifted signal comprises highest spectral components of the radio frequency signal and each further frequency shifted signal comprises next lower spectral components of the radio frequency signal. Such well ordered operation provides for better system performance and higher transmitter efficiency.

According to a further aspect the present invention relates to a computer program product for adjusting predistortion of a radio frequency signal in a feedback path of a radio transmitter, the computer program product comprising a computer readable medium, having thereon computer program code means, when said program is loaded, to make a computer executable for carrying out the above described method.

According to a further aspect the present invention relates to a radio communication base station comprising a radio transmitter as described above. For example, the base station is a GSM, UMTS, WiMAX or LTE base station.

According to a further aspect the present invention relates to a mobile station comprising a radio transmitter as described above.

According to a still further aspect the present invention relates to a radio communication system comprising at least one such base station and at least one such mobile station.

These and other aspects of the present invention will be apparent from and elucidated with reference to the embodiments thereafter. It should be noted that the use of reference signs shall not be construed as limiting the scope of the invention.

### Brief description of the drawings

- Figure 1: schematically shows a radio transmitter having a feedback path;
- Figure 2: shows a spectral diagram and its processing according to the present invention;
- Figure 3: shows a flow chart of a predistortion adjusting method according to the present invention.

### Detailed description of the drawings

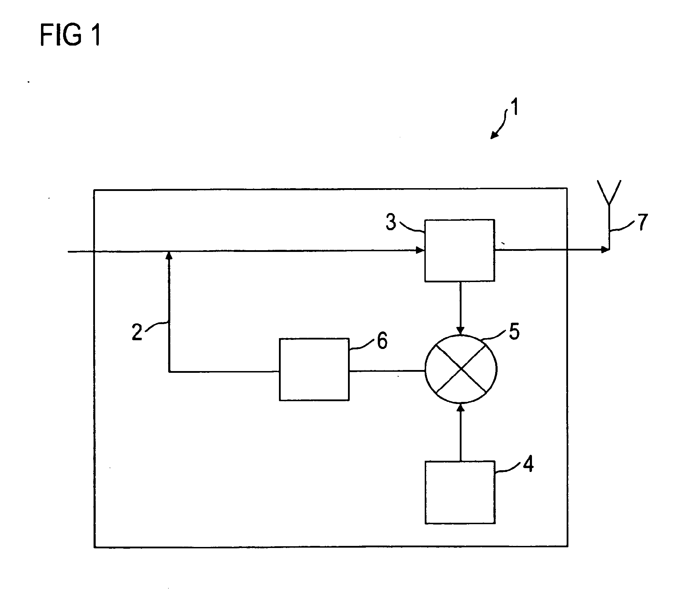

Figure 1 schematically shows a radio transmitter 1 having a feedback path 2. The feedback path 2 includes at least a coupler 3, a local oscillator 4, a mixer 5, and an analogue-to-digital converter 6. The coupler 3 is adapted to couple the radio frequency output signal of the transmitter 1, which is also fed to an antenna 7 (e.g. of a base station or a mobile station), to the predistortion feedback path 2. The local oscillator 4 is adapted to successively generate at least two different frequencies fed to the mixer 5. Based on said different frequencies the mixer 5 is able to generate different frequency shifted signals by multiplying the feedback signal by said frequencies. Then, the analogue-to-digital converter 6 successively converts said frequency shifted signals into digital signals. Finally, the generated digital signals are summed up to a single digital signal by appropriate means (not shown). It is also possible to couple a plurality of bandwidth sections of the feedback signal to the predistortion feedback path 2. In such case, not the total bandwidth of the feedback signal but several bandwidth sections thereof are successively multiplied by different frequencies in the mixer 5.

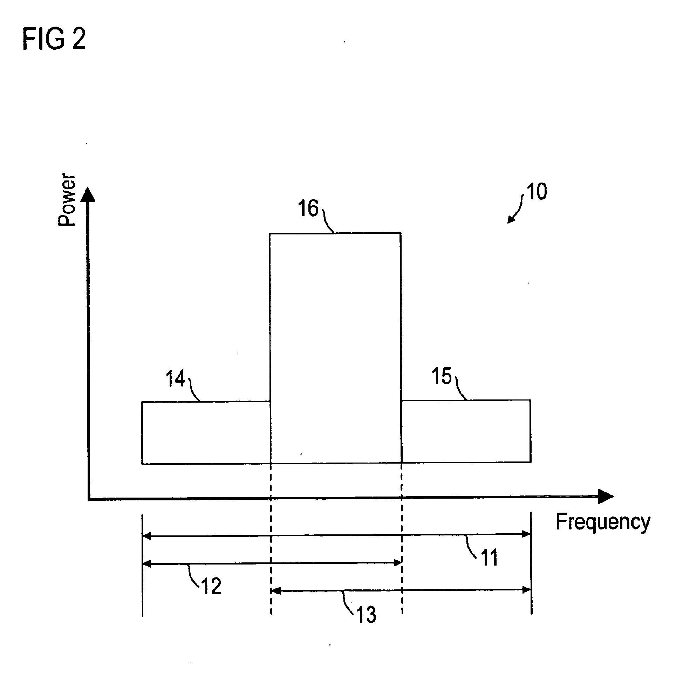

Figure 2 shows a spectral diagram 10 and its processing according to the present invention. More precisely, the spectral diagram 10 shows the splitting of the total bandwidth 11 of the radio frequency signal (feedback signal) into a first bandwidth section 12 and a second bandwidth section 13. However, if desired or required the total bandwidth 11 can be divided into more than two bandwidth sections 12, 13. The radio transmitter described with respect to figure 1 usually comprises an amplifier unit (not shown) having non-linear properties. As shown in figure 2 the output signal of the amplifier unit comprises first and second intermodulation distortion signals 14, 15 which are located symmetrically at frequencies below and above the desired output signal 16, wherein the spectral components of one side, either above or below the desired signal, are correlated to the spectral components of the other side, for example due to physical effects which can be described using mathematical methods. To compensate the non-linear properties of the amplifier unit the radio transmitter according to the present invention comprises a feedback path to which the above described signal is coupled in whole or in part, comprising in frequency domain the wanted output signal band 16 and first and second intermodulation distortion signal sidebands 14, 15. Preferably, the total bandwidth 11 of the signal coupled to the feedback path shown in figure 1 is divided into limited bandwidth sections 12, 13. That is, as shown in figure 2 the total bandwidth 11 is divided into two limited bandwidth sections 12, 13, which are smaller than the total bandwidth 11 and which overlap partially.

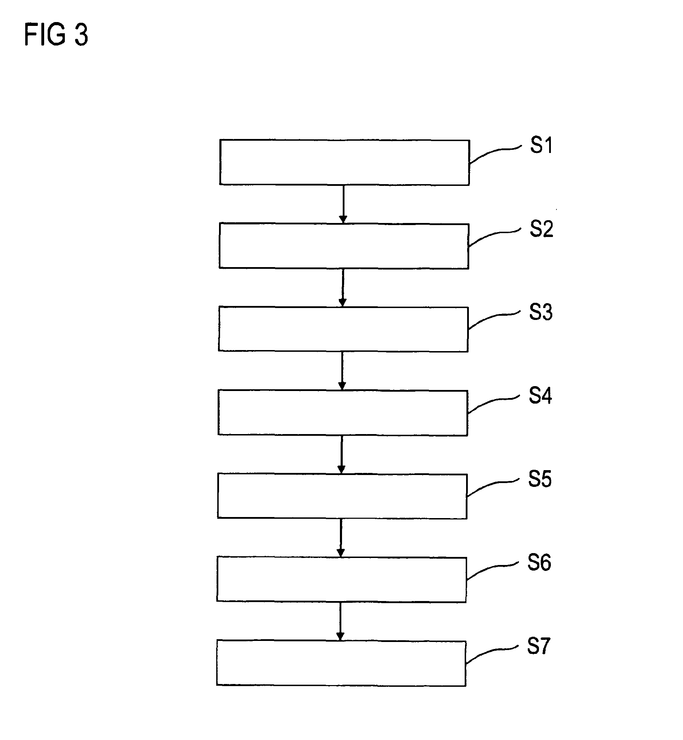

Figure 3 shows a flow chart of a predistortion adjusting method according to the present invention. In a first step S1 a first bandwidth section of the radio frequency signal being smaller than the total bandwidth of the radio frequency signal is determined. In a second step S2 a first frequency shifted signal is generated by multiplying the first bandwidth section by a first frequency. In a third step S3 said first frequency shifted signal is converted into a first digital signal. In a fourth step S4 a further bandwidth section of the radio frequency signal is determined. In a fifth step S5 at least one further frequency shifted signal is generated by multiplying said further bandwidth section by another frequency. In a sixth step S6 said further frequency shifted signal is converted into a further digital signal. In a final step S7 the generated digital signals are summed up to one single digital signal.

Some of the above steps can be performed in one single step or in several substeps. For example, it is possible to firstly determine all bandwidth sections of the total bandwidth of the radio frequency signal and, subsequently, to successively couple said bandwidth sections into the feedback path. In addition, as already described above the total bandwidth of the radio frequency signal can be divided into more than two bandwidth section resulting in the corresponding number of additional steps to be performed until all frequency components of the radio frequency signal are processed/converted.

## Claims

1. Method for adjusting predistortion of a radio frequency signal in a feedback path (2) of a radio transmitter (1), said radio frequency signal comprising a wanted signal band (16) and first and second intermodulation distortion signal sidebands (14, 15) in frequency domain, the method comprising the steps of:
- generating (S2) a first frequency shifted signal by multiplying the radio frequency signal by a first frequency;
- converting (S3) said first frequency shifted signal into a first digital signal;
- generating (S5) at least one further frequency shifted signal by multiplying the radio frequency signal by another frequency; and
- converting (S6) said at least one further frequency shifted signal into a further digital signal;
**characterized by**
- determining (S1) a first bandwidth section (12) of the radio frequency signal;
- generating (S2) the first frequency shifted signal based on said first bandwidth section (12) of the radio frequency signal;
- determining (S4) at least one further bandwidth section (13) of the radio frequency signal;
- generating (S5) at least one further frequency shifted signal based on said at least one further bandwidth section (13) of the radio frequency signal; and
- summing up (S7) said first and further digital signals,
wherein each bandwidth section (12, 13) is smaller than the total bandwidth (11) of the radio frequency signal.

2. Method according to claim 1, wherein the at least two bandwidth sections (12, 13) cover the total bandwidth (11) of the radio frequency signal.

3. Method according to claim 1 or 2, wherein the at least two bandwidth sections (12, 13) are multiplied by different frequencies when generating the frequency shifted signals.

4. Method according to any of claims 1 to 3, wherein the at least two bandwidth sections (12, 13) overlap partially.

5. Method according to any of the preceding claims, wherein the first frequency shifted signal comprises lowest spectral components of the radio frequency signal and wherein each further frequency shifted signal comprises next higher spectral components of the radio frequency signal or vice versa.

6. Computer program product for adjusting predistortion of a radio frequency signal in a feedback path (2) of a radio transmitter (1), the computer program product comprising a computer readable medium, having thereon computer program code means, when said program is loaded, to make a computer executable for carrying out the method according to any of the claims 1 to 5.

7. Radio transmitter (1) comprising in a predistortion feedback path (2) a coupler (3), a local oscillator (4), a mixer (5), and an analogue-to-digital converter (6), wherein:
- the coupler (3) is adapted to couple a radio frequency output signal of said radio transmitter (1) to the predistortion feedback path (2);
- the local oscillator (4) is adapted to generate a first frequency;
- the mixer (5) is adapted to generate a first frequency shifted signal by multiplying the radio frequency output signal by the first frequency;
- the analogue-to-digital converter (6) is adapted to convert said first frequency shifted signal into a first digital signal;
- the local oscillator (4) is adapted to generate another frequency;
- the mixer (5) is adapted to generate at least one further frequency shifted signal by multiplying the radio frequency output signal by said another frequency; and
- the analogue-to-digital converter (6) is adapted to convert said at least one further frequency shifted signal into a further digital signal;
**characterized in that**
- the coupler (3) is further adapted to successively couple first and further bandwidth sections (12, 13) of the output signal to the predistortion feedback path (2), wherein each bandwidth section (12, 13) is smaller than the total bandwidth (11) of the output signal;
- the mixer (5) is further adapted to generate the first and further frequency shifted signals based on the first and further bandwidth sections (12, 13); and
- the radio transmitter (1) further comprises means to sum up said first and further digital signals.

8. A radio communication base station comprising a radio transmitter (1) according to claim 7.

9. A mobile station comprising a radio transmitter (1) according to claim 7.

10. A radio communication system comprising at least one base station according to claim 8 and at least one mobile station according to claim 9.

## Patentansprüche

1. Verfahren zum Einstellen der Vorverzerrung eines Hochfrequenzsignals in einem Rückkopplungspfad (2) eines Funksenders (1), wobei das besagte Hochfrequenzsignal ein gewünschtes Signalband (16) sowie ein erstes und ein zweites Intermodulatlonsverzerrungssignal-Seitenband (14, 15) Im Frequenzbereich umfasst, wobei das Verfahren die folgenden Schritte umfasst:
- Erzeugen (S2) eines ersten frequenzverschobenen Signals durch Multiplizieren des Hochfrequenzsignals mit einer ersten Frequenz;
- Umwandeln (S3) des besagten ersten frequenzverschobenen Signals in ein erstes digitales Signal;
- Erzeugen (S5) mindestens eines weiteren frequenzverschobenen Signals durch Multiplizieren des Hochfrequenzsignals mit einer anderen Frequenz; und
- Umwandeln (S6) des besagten mindestens einen weiteren frequenzverschobenen Signals in ein welteres digitales Signal;
**gekennzeichnet durch**
- Ermitteln (S1) eines ersten Bandbreitenabschnitts (12) des Hochfrequenzsignals:
- Erzeugen (S2) des ersten frequenzverschobenen Signals auf der Basis des besagten ersten Bandbreitenabschnitts (12) des Hochfrequenzsignals;
- Ermitteln (S4) mindestens eines weiteren Bandbreltenabschnitts (13) des Hochfrequenzsignals;
- Erzeugen (S5) mindestens eines weiteren frequenzverschobenen Signals auf der Basis des besagten mindestens einen weiteren Bandbreltenabschnltts (13) des Hochfrequenzsignals; und
- Zusammenfassen (S7) des besagten ersten und der weiteren digitalen Signale,
wobei jeder Bandbreitenabschnitt (12, 13) kleiner als die Gesamtbandbreite (11) des Hochfrequenzsignals ist.

2. Verfahren nach Anspruch 1, wobei die mindestens zwei Bandbreitenabschnitte (12, 13) die Gesamtbandbreite (11) des Hochfrequenzsignals abdecken.

3. Verfahren nach Anspruch 1 oder 2, wobei die mindestens zwei Bandbreitenabschnitte (12, 13) bei der Erzeugung des frequenzverschobenen Signal mit unterschiedlichen Frequenzen multipliziert werden.

4. Verfahren nach einem beliebigen der Ansprüche 1 bis 3, wobei sich die mindestens zwei Bandbreitenabschnitte (12, 13) teilweise überlappen.

5. Verfahren nach einem beliebigen der vorstehenden Ansprüche, wobei das erste frequenzverschobene Signal niedrigste Spektralanteile des Hochfrequenzsignals umfasst, und wobei jedes weitere frequenzverschobene Signal nächst höhere Spektralanteile des Hochfrequenzsignals umfasst, oder umgekehrt.

6. Computerprogramm-Produkt zum Einstellen der Vorverzerrung eines Hochfrequenzsignals in einem Rückkopplungspfad (2) eines Funksenders (1), wobei das Computerprogramm-Produkt ein computerlesbares Medium umfasst, auf welchem Computerprogramm-Codiermittel gespeichert sind, um, wenn das besagte Programm geladen ist, zu veranlassen, dass ein Computer das Verfahren gemäß einem beliebigen der Ansprüche 1 bis 5 durchführt.

7. Funksender (1), umfassend einen Vorverzerrungsrückkopplungspfad (2), einen Koppler (3), einen lokalen Oszillator (4), einen Mischer (5) und einen Analog-zu-Digitalwandler (6), wobei:
- der Koppler (3) dazu ausgelegt ist, ein Hochfrequenz-Ausgangssignal des besagten Funksenders (1) an den Vorverzerrungsrückkopplungspfad (2) zu koppeln;
- der lokale Oszillator (4) dazu ausgelegt ist, eine erste Frequenz zu erzeugen;
- der Mischer (5) dazu ausgelegt ist, ein erstes frequenzverschobenes Signal durch Multiplizieren des Hochfrequenz-Ausgangssignals mit der ersten Frequenz zu erzeugen;
- der Analog-zu-Digitalwandler (6) dazu ausgelegt ist, das besagte erste frequenzverschobene Signal in ein erstes digitales Signal umzuwandeln;
- der lokale Oszillator (4) dazu ausgelegt ist, eine andere Frequenz zu erzeugen;
- der Mischer (5) dazu ausgelegt ist, mindestens ein weiteres frequenzverschobenes Signal durch Multiplizieren des Hochfrequenzausgangssignals mit der besagten anderen Frequenz zu erzeugen; und
- der Analog-zu-Digitalwandler (6) dazu ausgelegt ist, das besagte mindestens eine weitere frequenzverschobene Signal in ein weiteres digitales Signal umzuwandeln;
**dadurch gekennzeichnet, dass**
- der Koppler (3) weiterhin dazu ausgelegt ist, den ersten und weitere Bandbreitenabschnitte (12, 13) des Ausgangssignals nacheinander an den Vorverzerrungsrückkopplungepfad (2) zu koppeln, wobei jeder Bandbreitenabschnitt (12, 13) kleiner als die Gesamtbandbreite (11) des Ausgangssignals ist;
- der Mischer (5) weiterhin dazu ausgelegt ist, das erste und weitere frequenzverschobene Signale auf der Basis der ersten und der weiteren Bandbreitenabschnitte (12, 13) zu erzeugen; und
- der Funksender (1) weiterhin Mittel zum Zusammenfassen des besagten ersten und der weiteren digitalen Signale umfasst.

8. Funkkommunikations-Basisstation, umfassend einen Funksender (1) gemäß Anspruch 7.

9. Mobilstation, umfassend einen Funksender (1) gemäß Anspruch 7.

10. Funkkommunikationssystem, umfassend mindestens eine Basisstation gemäß Anspruch 8, und mindestens eine Mobilstation gemäß Anspruch 9.

## Revendications

1. Procédé pour ajuster la prédistorsion d'un signal en radiofréquence dans un trajet de contre-réaction (2) d'un émetteur radioélectrique (1), ledit signal en radiofréquence comprenant une bande de signal utile (16) ainsi qu'une première et une deuxième bandes latérales de signal de distorsion d'intermodulation (14, 15) dans le domaine de fréquence, le procédé comprenant les étapes suivantes :
- génération (S2) d'un premier signal décalé en fréquence en multipliant le signal en radiofréquence par une première fréquence ;
- conversion (S3) dudit premier signal décalé en fréquence en un premier signal numérique ;
- génération (S5) d'au moins un signal décalé en fréquence supplémentaire en multipliant le signal en radiofréquence par une autre fréquence ; et
- conversion (S6) dudit au moins un signal décalé en fréquence supplémentaire en un signal numérique supplémentaire ;
**caractérisé par les étapes suivantes**
- détermination (S1) d'une première section de largeur de bande (12) du signal en radiofréquence ;
- génération (S2) du premier signal décalé en fréquence en se basant sur ladite première section de largeur de bande (12) du signal en radiofréquence ;
- détermination (S4) d'au moins une section de largeur de bande supplémentaire (13) du signal en radiofréquence ;
- génération (S5) d'au moins un signal décalé en fréquence supplémentaire en se basant sur ladite au moins une section de largeur de bande supplémentaire (13) du signal en radiofréquence ; et
- addition (S7) dudit premier signal et dudit signal supplémentaire,
chaque section de largeur de bande (12, 13) étant inférieure à la largeur de bande totale (11) du signal en radiofréquence.

2. Procédé selon la revendication 1, selon lequel les au moins deux sections de largeur de bande (12, 13) couvrent la largeur de bande totale (11) du signal en radiofréquence.

3. Procédé selon la revendication 1 ou 2, selon lequel les au moins deux sections de largeur de bande (12, 13) sont multipliées par des fréquences différentes lors de la génération des signaux décalés en fréquence.

4. Procédé selon l'une quelconque des revendications 1 à 3, selon lequel les au moins deux sections de largeur de bande (12, 13) se chevauchent partiellement.

5. Procédé selon l'une quelconque des revendications précédentes, selon lequel le premier signal décalé en fréquence comprend les composantes spectrales les plus basses du signal en radiofréquence et selon lequel chaque signal décalé en fréquence supplémentaire comprend les composantes spectrales immédiatement supérieures du signal en radiofréquence ou inversement.

6. Produit de programme informatique pour régler la prédistorsion d'un signal en radiofréquence dans un trajet de contre-réaction (2) d'un émetteur radioélectrique (1), le produit de programme Informatique comprenant un support lisible par ordinateur sur lequel se trouvent des moyens de code de programme Informatique qui, lorsque ledit programme est chargé, permettent d'utiliser un ordinateur pour mettre en oeuvre le procédé selon l'une quelconque des revendications 1 à 5.

7. Émetteur radioélectrique (1) comprenant dans un trajet de contre-réaction (2) à prédistorsion un coupleur (3), un oscillateur local (4), un mélangeur (5) et un convertisseur analogique/numérlque (6), avec lequel :
- le coupleur (3) est adapté pour coupler un signal de sortie en radiofréquence dudit émetteur radioélectrique (1) au trajet de contre-réaction (2) à prédistorsion ;
- l'oscillateur local (4) est adapté pour générer une première fréquence ;
- le mélangeur (5) est adapté pour générer un premier signal décalé en fréquence en multipliant le signal de sortie en radiofréquence par la première fréquence ;
- le convertisseur analogique/numérique (6) est adapté pour convertir ledit signal décalé en fréquence en un premier signal numérique ;
- l'oscillateur local (4) est adapté pour générer une autre fréquence ;
- le mélangeur (5) est adapté pour générer au moins un signal décalé en fréquence supplémentaire en multipliant le signal de sortie en radiofréquence par ladite autre fréquence ;
- le convertisseur analogique/numérique (6) est adapté pour convertir ledit au moins un signal décalé en fréquence supplémentaire en un signal numérique supplémentaire ;
**caractérisé en ce que**
- le coupleur (3) est en outre adapté pour coupler successivement la première section et la section supplémentaire de largeur de bande (12, 13) du signal de sortie au trajet de contre-réaction (2) à prédistorsion, chaque section de largeur de bande (12, 13) étant Inférieure à la largeur de bande totale (11) du signal de sortie ;
- le mélangeur (5) est en outre adapté pour générer le premier signal et le signal supplémentaire décalés en fréquence en se basant sur la première section et la section supplémentaire de largeur de bande (12, 13) ; et
- l'émetteur radioélectrique (1) comprend en outre des moyens pour additionner lesdits signaux numériques, le premier et le supplémentaire.

8. Station de base de radiocommunication comprenant un émetteur radioélectrique (1) selon la revendication 7.

9. Station mobile comprenant un émetteur radioélectrique (1) selon la revendication 7.

10. Système de communication comprenant au moins une station de base selon la revendication 8 ou au moins une station mobile selon la revendication 9.
